# EUROPÄISCHE PATENTSCHRIFT

(11) **EP 2 815 474 B1**
(45) Veröffentlichungstag und Bekanntmachung des Hinweises auf die Patenterteilung: **23.03.2016**
(21) Anmeldenummer: 13700388.5
(22) Anmeldetag: 15.01.2013
(51) Int. Cl.: H02B 1/052

(54) **KLEMMBEFESTIGUNG ZUR BEFESTIGUNG EINES GEHÄUSES AN EINER SCHIENE**
CLAMPING ASSEMBLY FOR FIXING A HOUSING TO A RAIL
FIXATION DE SERRAGE POUR LA FIXATION D'UN BOÎTIER SUR UN RAIL

(30) Priorität: 13.02.2012 EP 12155061
(43) Veröffentlichungstag der Anmeldung: 24.12.2014
(73) Patentinhaber: Siemens Aktiengesellschaft, 80333 München (DE)
(72) Erfinder: PETRICEK, Martin, A-2020 Hollabrunn (AT)
(74) Vertreter: Maier, Daniel Oliver
(86) Internationale Anmeldenummer: PCT/EP2013/050626
(87) Internationale Veröffentlichungsnummer: WO 2013/120643

(56) Entgegenhaltungen:
- EP-A1- 2 626 962
- DE-U1-202010 008 319
- US-A1- 2006 079 124

## Beschreibung

### Technisches Gebiet

Die Erfindung betrifft eine Klemmbefestigung zur Befestigung eines Gehäuses an einer Schiene, etwa einer Hutschiene, mit einem Schieber, der an die Schiene klemmbar ist.

### Stand der Technik

Solche Befestigungen werden auch als Schnappbefestigungen bezeichnet. Sie kommen in Verbindung mit Reiheneinbaugeräten, insbesondere mit Schaltern aus Sammelschienenverbünden, zum Einsatz. Das Reiheneinbaugerät weist hierbei ein Gehäuse auf, welches eine für den Sammelschienenverbund vorteilhafte Form aufweist. Einerseits werden aus Platzgründen eine Ansammlung der Reiheneinbaugeräte dadurch unterstützt, dass das Gehäuse des Reiheneinbaugerätes, welches beispielsweise als Schalter oder Schutzschalter ausgeführt ist, eine flächige Anordnung weiterer Gehäuse auf zwei oder mehr Seiten zulässt und gleichzeitig eine Klemm- oder Schnappbefestigung aufweist, die zur Befestigung des Gehäuses an einer Schiene, insbesondere einer Hutschiene, vorgesehen ist.

Ein solcher Schalter oder Schutzschalter wird mit Hilfe eines Schiebers auf der Hutschiene fixiert. Problematisch ist hierbei, dass die Hutschiene bei der Benutzung des Schalters auf der dem Benutzer abgewandten Seite angeordnet ist und ein Lösen aus dem Sammelschienenverbund aufgrund mangelnder Zugänglichkeit wegen räumlich naheliegender Schalter nicht ohne weiteres zu bewerkstelligen ist. Folglich weisen herkömmliche Schieber ein Betätigungselement auf, welches vom Benutzer auch im montierten Zustand stets zugänglich ist und weisen weiter ein Verriegelungselement auf, welches an der Rückseite des Gehäuses in der Nähe der Schiene angeordnet ist. Beide Elemente werden über einen Verbindungsbereich verbunden. Der Verbindungsbereich hat die Aufgabe, die Betätigungskraft, die vom Benutzer auf das Betätigungselement ausgeübt wird in die Bewegungslinie des Verriegelungselementes umzulenken.

Gleichzeitig sollen komfortable Methoden der Montage bzw. Demontage des Schalters gewährleistet sein. Für die Demontage ist das Betätigungselement vom Schalter in Richtung Benutzer bewegbar, wobei eine Entriegelung durch eine entsprechende Bewegung des Verriegelungselementes gewährleistet ist.

Aufgrund der aufwendigen Form des Schiebers wurden in der Vergangenheit aufwendige mehrteilige Schieber verwendet. Aus DE 297 10 310 U1 ist ein mehrteiliger Schieber bekannt, der in einen verriegelnden und einen separaten, betätigenden Teil aufgeteilt ist.

Die DE 10 2007 015 470 A1 offenbart eine Schnappbefestigung zur Befestigung eines Gehäuses an einer Schiene mit einem Schieber, wobei der Schieber ein Betätigungselement, ein Verriegelungselement und einen Verbindungsbereich zwischen dem Betätigungselement und dem Verriegelungselement zur Umlenkung der Richtung der Betätigungskraft, die über den Verbindungsbereich auf das Verriegelungselement wirkt, aufweist. Beim einstückigen Schieber ist zumindest der Verbindungsbereich elastisch rückstellend ausgeführt.

Keine der beiden genannten Veröffentlichungen DE 297 10 310 U1 und DE 10 2007 015 470 A1 zeigen jedoch eine Lösung, wie mehrere Gehäuse des Reiheneinbaugerätes untereinander mechanisch verbunden werden können.

Die US 2006079124 A1 offenbart durch einen vorspringenden Abschnitt eines Schiebes miteinander verbundene Reiheneinbaugeräte

### Darstellung der Erfindung

Es ist eine Aufgabe der vorliegenden Erfindung, eine Klemmbefestigung zur Verfügung zu stellen, welche nicht nur das Klemmen eines Gehäuses an eine Schiene bewerkstelligt, sondern auch das Verbinden benachbarter Gehäuse untereinander.

Diese Aufgabe wird durch eine Klemmbefestigung mit den Merkmalen des Patentanspruchs 1 gelöst. Vorteilhafte Ausgestaltungen der Erfindung sind in den jeweiligen abhängigen Ansprüchen definiert.

Gemäß Anspruch 1 ist eine Klemmbefestigung zur Befestigung eines Gehäuses an einer Schiene mit einem Schieber vorgesehen, wobei zur gleichzeitigen Verbindung des Gehäuses mit einem benachbarten, bereits auf der Schiene befestigten Gehäuse, der Schieber mittels einer, als weiterer Schieber ausgebildeten Schiebersperre, die durch das benachbarte Gehäuse betätigbar ist, in die Klemmposition überführbar ist und der Schieber zusätzlich eine Gehäuseverriegelung zur Verriegelung des Gehäuses mit dem benachbarten Gehäuse beim Überführen des Schiebers in die Klemmposition aufweist.

Dadurch wird beim Heranführen des Gehäuses mit dem erfindungsgemäßen Schieber an ein bereits auf die Schiene geklemmtes Gehäuse die Schiebersperre von der Wand dieses benachbarten Gehäuses in das Gehäuse hineingeschoben und der Schieber wird gelöst, sodass der Schieber von der offenen Position in die Klemmposition übergeführt wird und während dieses Weges gleichzeitig die Gehäuseverriegelung mit einem entsprechenden Gegenstück am benachbarten Gehäuse in Eingriff gebracht wird. Nachdem der Schieber also die Klemmposition erreicht hat, ist das Gehäuse auch mit dem benachbarten Gehäuse verriegelt.

Dabei kann vorgesehen sein, dass die Schiebersperre in gerader Richtung verschiebbar ist, und zwar normal zu jener Richtung, in welcher der Schieber in die Klemmposition verschiebbar ist. Wenn sich also der Schieber im eingebauten Zustand an der Rückwand des Gehäuses befindet und von unten nach oben in die Klemmposition gebracht wird, dann wird die Schiebersperre, waagrecht, etwa von links nach rechts, verschiebbar sein.

Eine Ausführungsform der Erfindung bezieht sich darauf, dass die Schiebersperre ein in Bewegungsrichtung der Schiebersperre vorspannbares Element aufweist, mit welchem die Schiebersperre an der Innenseite eines Gehäuses befestigbar ist. Das vorspannbare Element kann etwa eine Feder, z.B. eine Schraubenfeder, sein.

Eine mechanische besonders einfache Ausgestaltung der Erfindung ergibt sich, wenn die Gehäuseverriegelung starr mit dem Schieber verbunden ist. Die Gehäuseverriegelung kann etwa Öffnungen aufweisen, die in Einhänglaschen des Schiebers eingehängt sind. Die gleichen Einhänglaschen können gleichzeitig zur Führung des Schiebers im Gehäuse verwendet werden.

Wenn der Schieber flächig ausgeführt ist, ist dieser in sich stabil und kann dieser einfach, etwa aus einem Metallblech, hergestellt werden. Der Schieber hat dann auch genug Platz, wenn er an der Rückseite des Gehäuses angeordnet ist. Etwaige Laschen des Schiebers können durch Biegen des Blechs hergestellt werden. Flächig bedeutet hier, dass die Länge und Breite des Schiebers die selbe Größenordnung haben und die Dicke des Schiebers inklusive etwaiger Einhängelaschen nur einen Bruchteil der Länge bzw. Breite beträgt, z.B. nur etwa ein Viertel.

Eine Ausführungsform der Erfindung sieht vor, dass der Schieber zumindest eine Einhänglasche aufweist, die zur Herstellung der Klemmposition des Schiebers mit einer Ausnehmung der Schiebersperre verrastbar ist. Dies stellt eine einfache Art des Eingriffs zwischen Schieber und Schiebersperre dar. Die gleichen Einhänglaschen können gleichzeitig zur Führung des Schiebers im Gehäuse verwendet werden.

Es kann vorgesehen sein, dass der Schieber - zum Halten des Schiebers in der offenen Position - einen, insbesondere auswechselbaren, Rasthaken aufweist. So kann der Schieber Laschen haben, über welche ein Plättchen mit einem Rasthaken gelegt wird. Dieser Rasthaken kann sich dann an einer entsprechenden Öffnung des Gehäuses, in der Regel in der Rückwand, abstützen und den Schieber in der offenen Position halten, wenn die Schiebersperre dies aufgrund ihrer Position nicht erfüllen kann. Der Rasthaken kann in der offenen Position des Schiebers zusätzlich mit einem Fortsatz der Schiebersperre in Eingriff sein, die den Rasthaken in Richtung Außenseite des Gehäuses drückt.

Die erfindungsgemäße Klemmbefestigung wird so in einem Gehäuse angeordnet, dass der Schieber in gerader Richtung (in der Regel jene Richtung, die - in Klemmposition des Gehäuses an der Schiene - normal zur Schiene verläuft) im Gehäuse verschiebbar gelagert ist, dass die Schiebersperre normal dazu (in der Regel in jener Richtung, die - in Klemmposition des Gehäuses an der Schiene - parallel zur Schiene verläuft) im Gehäuse verschiebbar gelagert ist, dass die Gehäuseverriegelung teilweise durch das Gehäuse hinausragt, wobei in der freien Position des Gehäuses (also wenn das Gehäuse auf der Schiene verschoben werden könnte) die Schiebersperre über das Gehäuse hinausragt und den vorgespannten Schieber in offener Position hält, während in der Klemmposition des Gehäuses (also wenn das Gehäuse an der Schiene festgeklemmt wäre) die Schiebersperre bezüglich der offenen Position in das Gehäuseinnere verschoben und der Schieber freigegeben ist.

Dadurch kann sich der Schieber aufgrund seiner Vorspannung in Richtung zum Gehäuse bewegen und wird seine Klemmposition einnehmen. Wenn das Gehäuse also auf eine Schiene aufgesetzt wird, würde der Schieber diese hintergreifen und das Gehäuse an der Schiene festklemmen.

Durch die Schiebersperre ist es möglich, dass Gehäuse mit geöffnetem Schieber auf die Hutschiene zu hängen und es noch immer längs der Hutschiene bewegen zu können.

Der Schieber ist am einfachsten an der Außenseite des Gehäuses angeordnet und mittels Einhänglaschen in entsprechenden Ausnehmungen des Gehäuses geführt.

Entsprechend könnte die Schiebersperre in gerader Richtung verschiebbar an der Innenseite des Gehäuses gelagert sein, und zwar normal zu jener Richtung, in welcher der Schieber aus der offenen Position in die Klemmposition verschiebbar ist.

Wenn der Schieber zum Halten des Schiebers in der offenen Position einen, insbesondere auswechselbaren, Rasthaken aufweist, der sich am Gehäuse abstützt und den Schieber in offener Position hält, hat dies folgenden Vorteil: Beim manuellen Öffnen des Schiebers muss dieser nicht so lange in offener Position gehalten werden, bis das Gehäuse so weit vom benachbarten Gehäuse entfernt, dass die Schiebersperre aufgrund ihrer Vorspannung (und des fehlenden Seitenteils des benachbarten Gehäuses) so weit verschoben wird, dass sie selbst den Schieber in der offenen Position hält.

### Kurzbeschreibung der Figuren

Zur weiteren Erläuterung der Erfindung wird im nachfolgenden Teil der Beschreibung auf die Figuren Bezug genommen, aus der weitere vorteilhafte Ausgestaltungen, Einzelheiten und Weiterbildungen der Erfindung zu entnehmen sind. Es zeigen:
Figur 1 eine Ansicht eines erfindungsgemäßen Gehäuses in offener Position auf einer Hutschiene,
Figur 2 das Gehäuse aus Fig. 1 in Klemmposition und verriegelt mit einem benachbarten Gehäuse,
Figur 3 das Gehäuse aus Fig. 1 bzw. 2 beim Öffnen der Gehäuseverriegelung,
Figur 4 das Gehäuse aus den Fig. 1 bis 3 nach dem Entfernen vom benachbarten Gehäuse,
Figur 5 einen Ausschnitt aus Fig. 1, wo der Schieber vergrößert dargestellt ist,
Figur 6 einen Schieber, und
Figur 7 einen Rasthaken.

### Ausführung der Erfindung

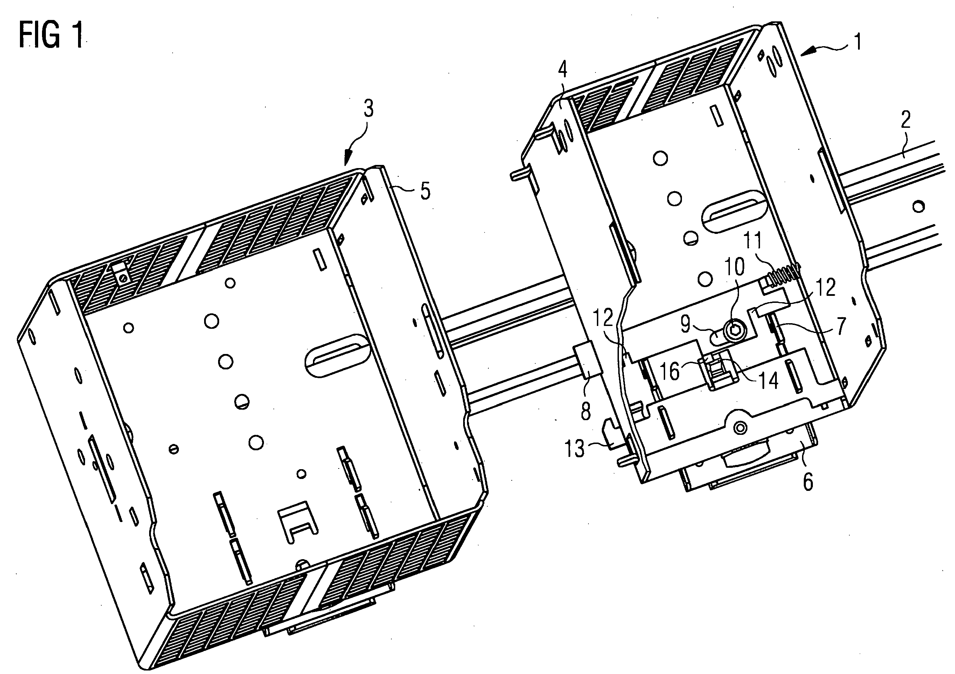

In Fig. 1 ist ein erfindungsgemäßes Gehäuse 1 dargestellt, das auf eine Hutschiene 2 aufgesetzt, jedoch noch nicht auf dieser festgeklemmt ist. Das links vom Gehäuse 1 dargestellte benachbarte Gehäuse 3 ist bereits an der Hutschiene 2 festgeklemmt. Beide Gehäuse weisen ebene Seitenwände 4, 5 auf, welche das Gehäuse begrenzen. Die Seitenwände 4, 5 stehen normal zur Ebene der Hutschiene 2.

Der Schieber 6 ist außerhalb des Gehäuses 1 angeordnet, nämlich an dessen Rückwand und ragt hinter dem Gehäuse 1, hier an der Unterseite, hervor, sodass er auch mit der Hand betätigt (verschoben) werden kann. Der Schieber 6 könnte auch so an der Rückwand des Gehäuses 1 angeordnet sein, dass er an der Oberseite des Gehäuses nach oben über das Gehäuse hinausragt.

Der Schieber 6 weist an seinen Längsseiten zumindest je eine Einhänglasche 7 auf, die zum Gehäuse 1 hin ausgerichtet ist und durch entsprechende Öffnungen in die Rückwand des Gehäuses 1 eingefädelt werden. Die Einhänglaschen 7 dienen als Führung für den Schieber 6, die rechte und linke obere Einhänglasche 7 stützt sich aber in Fig. 1 auch an der Schiebersperre 8 ab. Der Schieber 6 ist in dieser Position, seiner offenen Position, vorgespannt.

Die Schiebersperre 8 ist ein länglicher, im Wesentlichen flacher Teil, etwa aus Blech, der mittels eines Langlochs 9 geführt wird, und zwar parallel zur Rückwand durch einen Stift oder eine Schraube 10, der bzw. die in der Rückwand des Gehäuses 1 befestigt ist. Das im Inneren des Gehäuses befindliche (rechte) Ende der Schiebersperre 8 ist mittels einer Schraubenfeder 11 mit der rechten Seitenwand des Gehäuses 1 verbunden. Die Schraubenfeder 11 ist in dieser Stellung der Schiebersperre 8 entspannt. Für das im Inneren des Gehäuses befindliche (rechte) Ende der Schiebersperre 8 dient die rechte Seitenwand des Gehäuses 1 als Anschlag, wenn die Schiebersperre gespannt wird.

Das andere (linke) Ende der Schiebersperre 8 ragt durch eine Öffnung des Gehäuses 1, genauer durch dessen Seitenwand 4, hinaus, und zwar so weit, wie die Einhänglaschen 7 in Längsrichtung der Schiebersperre 8 von den Ausnehmungen 12 entfernt sind.

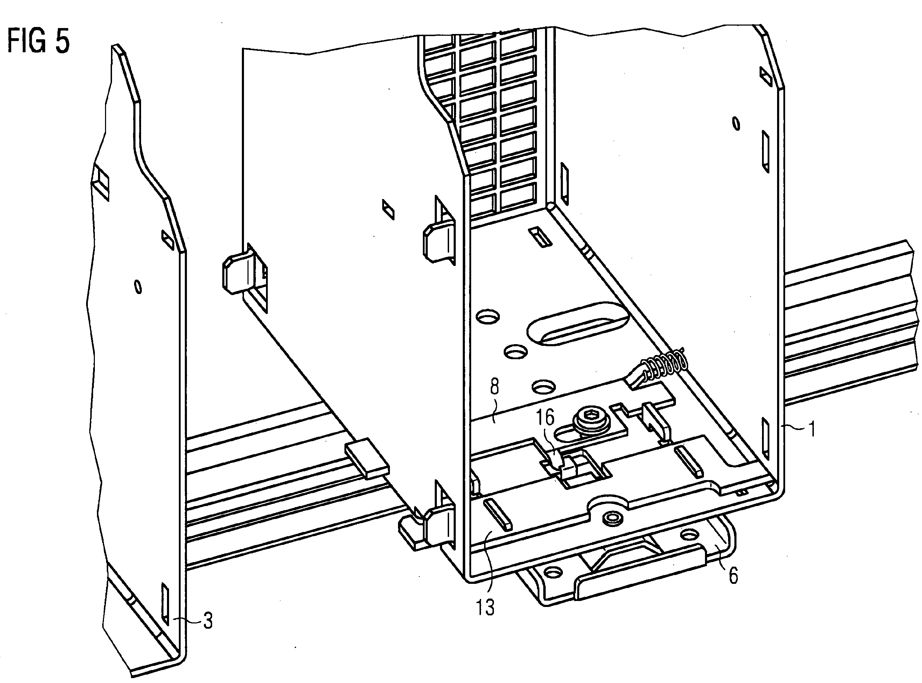

Die Gehäuseverriegelung 13, von der hier nur ein nach oben gebogener Haken sichtbar ist, ist als ebener Streifen ausgebildet und weist Öffnungen auf, durch welche die unteren Einhänglaschen 7 des Schiebers 6 ragen, siehe hierzu auch Fig. 5, und auf diese Weise die Gehäuseverriegelung 13 starr mit dem Schieber 6 verbinden. Die Gehäuseverriegelung 13 kann beispielsweise als Blechstreifen ausgebildet sein, sie kann aber auch mittels Druckguss hergestellt werden oder aus Kunststoff mittels Kunststoffspritzguss.

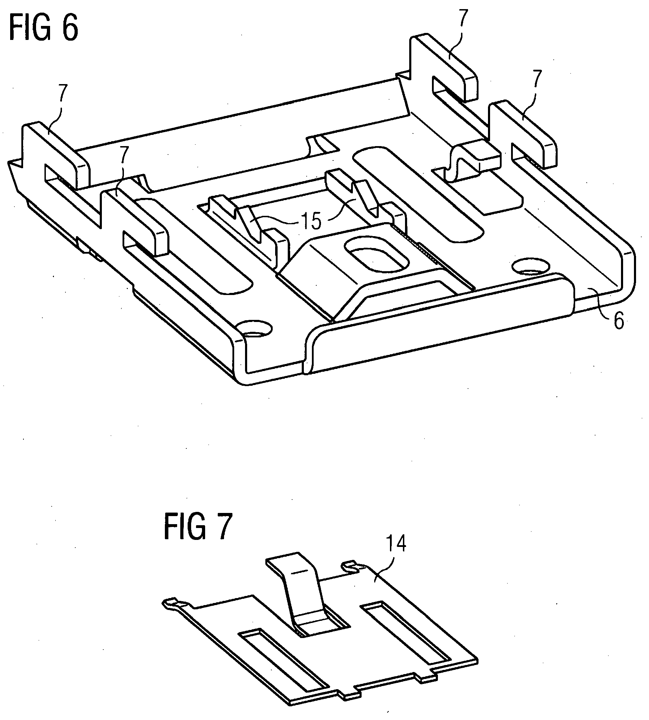

Auf dem Schieber 6 ist weiters ein - hier auswechselbarer - Rasthaken 14 vorgesehen, der den Schieber ebenfalls in der offenen Position hält. Dabei stützt sich der Rasthaken 14 an einer Ausnehmung oder einer ähnlichen Einrichtung an der Rückwand des Gehäuses ab. Der Rasthaken 14 ist mittels Ausnehmungen in entsprechende Laschen 15 des Schiebers 6 eingehängt, siehe Fig. 6, und wird durch die teilweise darüber angeordnete Gehäuseverriegelung 13 fixiert. Der Rasthaken 14 könnte jedoch ebenso einteilig mit dem Schieber 6 ausgeführt oder nicht lösbar mit diesem verbunden sein.

Im mittleren Bereich der Schiebersperre 8 ist ein Fortsatz vorgesehen, welcher mit dem Rasthaken 14 in der offenen Position des Schiebers in Eingriff ist und diesen in Richtung Außenseite des Gehäuses drückt.

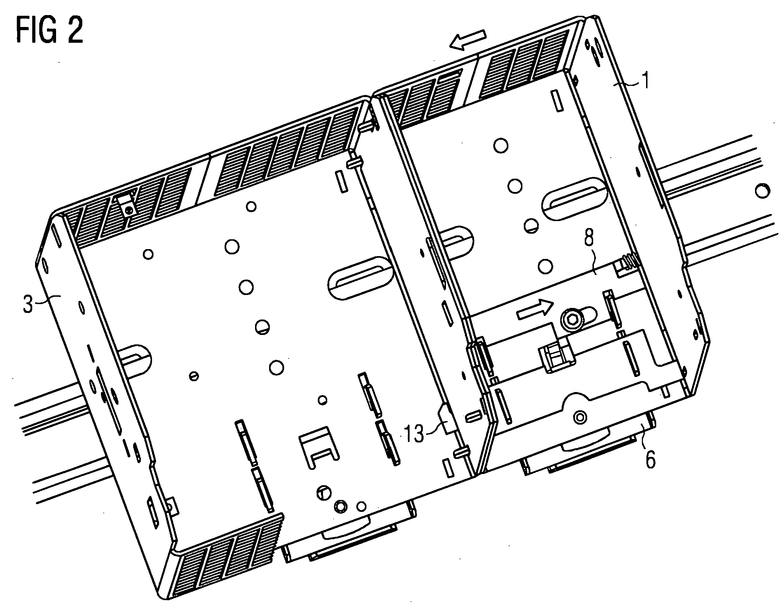

Wenn nun das Gehäuse 1 auf der Hutschiene 2 nach links zum benachbarten Gehäuse 3 verschoben wird, siehe Pfeil in Fig. 2 oben, nähern sich die Seitenwände 3, 4 der beiden Gehäuse 1, 3 an. Die Seitenwand 3 drückt dann die Schiebersperre 8 in das Gehäuse 1 (nach rechts) hinein, siehe Pfeil in Fig. 2, und zwar so weit, bis die oberen Einhänglaschen 7 des vorgespannten Schiebers 6 in die Ausnehmungen 12 einrasten, der vorgespannte Schieber 6 als freigegeben wird. Weiter kann die Schiebersperre 8 nicht ins Gehäuse 1 geschoben werden, weil das rechte Ende der Schiebersperre 8 bereits die rechte Seitenwand des Gehäuses 1 berührt. Durch das Verschieben der Schiebersperre 8 wird die Schraubenfeder 11 gespannt, der Schieber 6 bewegt sich entlang der Rückwand nach oben in seine Klemmposition und klemmt das Gehäuse 1 an der Hutschiene 2 fest. Der Schieber 6 befindet sich nun in seiner entspannten Position.

Mit dem Schieber 6 bewegt sich aber auch die Geräteverriegelung 13 nach oben, der aus dem Gehäuse 1 in das benachbarte Gehäuse 3 ragende Haken hakt sich in der Seitenwand 5 ein und verbindet damit die beiden Gehäuse 1, 3 mechanische miteinander. Dadurch wird ihre gegenseitige Position in Richtung der Hutschiene 2 festgelegt. Der Rasthaken 14 wandert während der Bewegung des Schiebers 6 hinter die Rückwand des Gehäuses. In Fig. 2 ist die soeben beschriebene Klemmposition dargestellt.

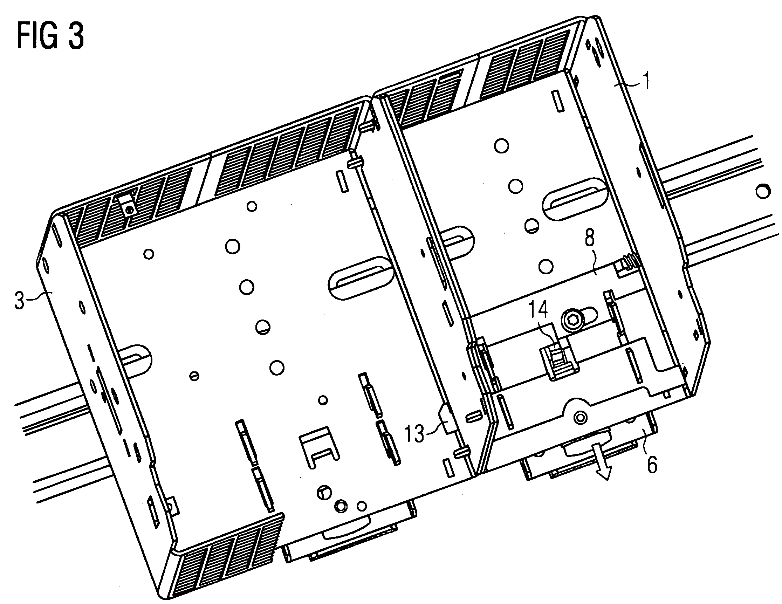

Sollen die beiden Gehäuse 1, 3 wieder voneinander gelöst und das Gehäuse 1 nach rechts bewegt werden, so wird der Schieber 6 händisch vom Gehäuse 1 weg, also wie in Fig. 3 durch den Pfeil dargestellt, nach unten geschoben, er wird gelöst. Dadurch löst sich die Gehäuseverriegelung 13 aus der Seitenwand 5, öffnet sich also, und kann durch die Öffnung der Seitenwand 5 nach rechts herausgezogen werden.

Durch das Herausziehen des Schiebers 6 wird auch die Klemmstellung gelöst, allerdings kann sich der Schieber 6 noch nicht - so wie in Fig. 1 - an der Schiebersperre 8 abstützen (obwohl seine Position jener in Fig. 1 entspricht), weil sich die Schiebersperre 8 noch nicht aus dem Gehäuse 1 (nach links) schieben kann, sie wird noch durch die Seitenwand 5 in das Gehäuse 1 (nach rechts) gedrückt.

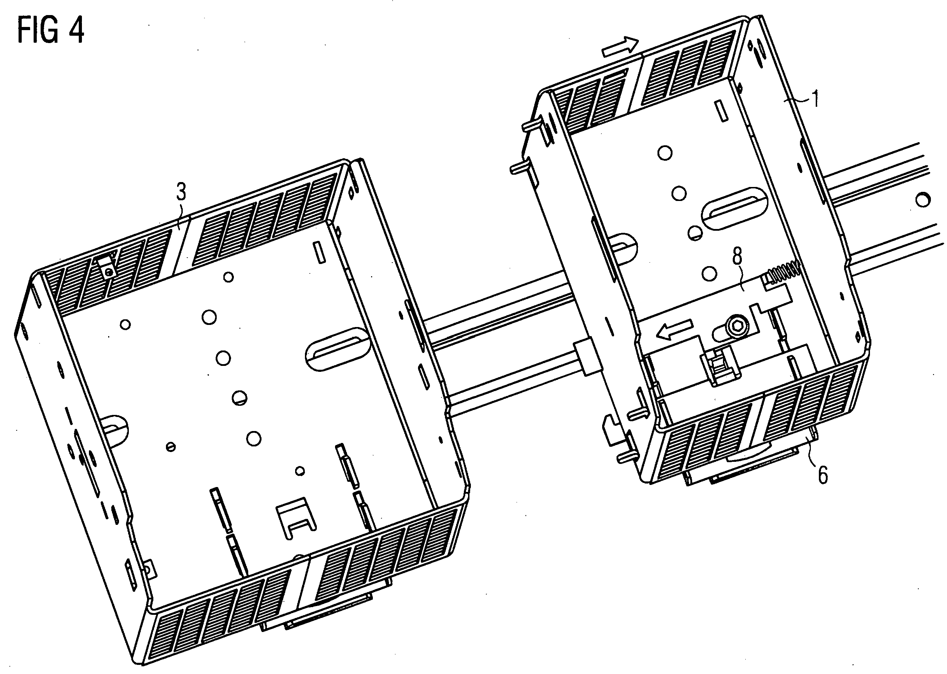

Jedoch ist die Position des Rasthakens 14 so gewählt, dass sich dieser an einer Öffnung der Rückwand abstützt und so den nun wieder vorgespannten Schieber 6 in der offenen Position hält. Das Gehäuse 1 kann nun - ohne dass der Schieber 6 ständig händisch in der offenen Position gehalten wird - entlang der Hutschiene 2 verschoben werden, siehe Pfeil oben in Fig. 4.

Sobald sich die beiden Seitenwände 4, 5 ausreichend weit voneinander entfernt haben, schiebt die Schraubenfeder 11 die Schiebersperre 8 wieder so weit aus dem Gehäuse 1 (nach links, siehe Pfeil in Fig. 4), bis der Schieber 6 wieder von der Schiebersperre 8 in der offenen Position gehalten werden kann. Der vorgespannte Schieber 6 wird durch den Rasthaken 14 teilweise freigegeben. Damit ist wieder der gleiche Zustand wie in Fig. 1 hergestellt.

In Fig. 5 ist die Gehäuseverriegelung 13 und ihre Befestigung am Schieber 6 besser erkennbar als in Fig. 1.

In Fig. 6 ist der Schieber 6 mit seinen vier Einhänglaschen 7 dargestellt. Weiters sind die beiden Laschen 15 für den Rasthaken 14 zu sehen. Der Rasthaken 14 weist einen ebenen Teil mit zwei Langlöchern auf, welche über die Laschen 15 passen und den Rasthaken 14 somit einfach durch Einlegen in den Schieber 6 in der Ebene des Schiebers fixieren. Die Fixierung normal zur Ebene des Schiebers 6 erfolgt durch die Gehäuseverriegelung 13, siehe etwa Fig. 1.

### Bezugszeichenliste:

- 1: Gehäuse
- 2: Hutschiene
- 3: benachbartes Gehäuse
- 4: Seitenwand des Gehäuses
- 5: Seitenwand des benachbarten Gehäuses
- 6: Schieber
- 7: Einhänglasche des Schiebers 6
- 8: Schiebersperre
- 9: Langloch
- 10: Stift oder Schraube
- 11: Schraubenfeder
- 12: Ausnehmungen der Schiebersperre 8 für die Einhänglaschen 7
- 13: Gehäuseverriegelung
- 14: Rasthaken
- 15: Laschen für den Rasthaken 14
- 16: Fortsatz an Schiebersperre 8

## Patentansprüche

1. Klemmbefestigung zur Befestigung eines Gehäuses (1) an einer Schiene (2), etwa einer Hutschiene, mit einem Schieber (6), der an die Schiene (2) klemmbar ist, **dadurch gekennzeichnet, dass** zur gleichzeitigen Verbindung des Gehäuses (1) mit einem benachbarten, bereits auf der Schiene befestigten Gehäuse (3), der Schieber (6) mittels einer, als weiterer Schieber ausgebildeten Schiebersperre (8), die durch das benachbarte Gehäuse (3) betätigbar ist, in die Klemmposition überführbar ist und der Schieber (6) zusätzlich eine Gehäuseverriegelung (13) zur Verriegelung des Gehäuses (1) mit dem benachbarten Gehäuse (3) beim Überführen des Schiebers (6) in die Klemmposition aufweist.

2. Klemmbefestigung nach Anspruch 1, **dadurch gekennzeichnet, dass** die Schiebersperre (8) in gerader Richtung verschiebbar ist, und zwar normal zu jener Richtung, in welche der Schieber (6) in die Klemmposition verschiebbar ist.

3. Klemmbefestigung nach Anspruch 1 oder 2, **dadurch gekennzeichnet, dass** die Schiebersperre (8) ein in Bewegungsrichtung der Schiebersperre vorspannbares Element (11) aufweist, mit welchem die Schiebersperre an der Innenseite eines Gehäuses (1) befestigbar ist.

4. Klemmbefestigung nach einem der Ansprüche 1 bis 3, **dadurch gekennzeichnet, dass** die Gehäuseverriegelung (13) starr mit dem Schieber (6) verbunden ist.

5. Klemmbefestigung nach einem der Ansprüche 1 bis 4, **dadurch gekennzeichnet, dass** der Schieber (6) flächig ausgeführt ist.

6. Klemmbefestigung nach einem der Ansprüche 1 bis 5, **dadurch gekennzeichnet, dass** der Schieber (6) zumindest eine Einhänglasche (7) aufweist, die zur Herstellung der Klemmposition des Schiebers mit einer Ausnehmung (12) der Schiebersperre (8) verrastbar ist.

7. Klemmbefestigung nach einem der Ansprüche 1 bis 6, **dadurch gekennzeichnet, dass** der Schieber (6) zum Halten des Schiebers in der offenen Position einen, insbesondere auswechselbaren, Rasthaken (14) aufweist.

8. Gehäuse (1) mit einer Klemmbefestigung nach einem der Ansprüche 1 bis 7, **dadurch gekennzeichnet, dass** der Schieber (6) in gerader Richtung im Gehäuse verschiebbar gelagert ist, dass die Schiebersperre (8) in einer Richtung normal dazu im Gehäuse verschiebbar gelagert ist, dass die Gehäuseverriegelung (13) teilweise durch das Gehäuse hinausragt, wobei in der freien Position des Gehäuses die Schiebersperre (8) über das Gehäuse hinausragt und den vorgespannten Schieber (6) in offener Position hält, während in der Klemmposition des Gehäuses die Schiebersperre (8) bezüglich der offenen Position in das Gehäuseinnere verschoben und der Schieber (6) freigegeben ist.

9. Gehäuse nach Anspruch 8, **dadurch gekennzeichnet, dass** der Schieber (6) an der Außenseite des Gehäuses (1) angeordnet ist und mittels Einhänglaschen (7) in entsprechenden Ausnehmungen des Gehäuses geführt ist.

10. Gehäuse nach Anspruch 8 oder 9, **dadurch gekennzeichnet, dass** die Schiebersperre (8) in gerader Richtung verschiebbar an der Innenseite des Gehäuses (1) gelagert ist, und zwar normal zu jener Richtung, in welcher der Schieber (6) aus der offenen Position in die Klemmposition verschiebbar ist.

11. Gehäuse nach einem der Ansprüche 8 bis 10, **dadurch gekennzeichnet, dass** der Schieber (6) zum Halten des Schiebers in der offenen Position einen, insbesondere auswechselbaren, Rasthaken (14) aufweist, der sich am Gehäuse (1) abstützt und den Schieber in offener Position hält.

## Claims

1. Clamp fastening for fastening a housing (1) to a rail (2), such as a top-hat rail, with a slider (6), which is able to be clamped on the rail (2), **characterised in that**, for simultaneous connection of the housing (1) with an adjacent housing (3) already fastened to the rail, the slider (6) is able by means of a slider lock (8) embodied as a further slider, which is able to be actuated through the adjacent housing (3), to be transferred into the clamping position and the slider (6) also has a housing lock (13) for locking the housing (1) with the adjacent housing (3) when the slider (6) is moved into the clamping position.

2. Clamp fastening according to claim 1, **characterised in that** the slider lock (8) is able to be moved in a straight line and indeed at right angles to that direction in which the slider (6) is able to be moved into the clamping position.

3. Clamp fastening according to claim 1 or 2, **characterised in that** the slider lock (8) has an element (11) able to be pre-tensioned in the direction of movement of the slider lock, with which the slider lock is able to be fastened to the inner side of a housing (1).

4. Clamp fastening according to one of claims 1 to 3, **characterised in that** the housing lock (13) is connected rigidly to the slider (6).

5. Clamp fastening according to one of claims 1 to 4, **characterised in that** the slider (6) is embodied planar.

6. Clamp fastening according to one of claims 1 to 5, **characterised in that** the slider (6) has at least one suspension tab (7) which is able to be locked to establish the clamping position of the slider with a cutout (12) of the slider lock (8).

7. Clamp fastening according to one of claims 1 to 6, **characterised in that** the slider (6), for holding the slider in the open position, has an, especially exchangeable, latching hook (14).

8. Housing (1) with the clamp fastening according to one of claims 1 to 7, **characterised in that** the slider (6) is supported to allow movement in a straight-line direction in the housing, that the slider lock (8) is supported to allow movement in a direction of right angles thereto in the housing, that the housing lock (13) partly projects through the housing, wherein in the free position of the housing the slider lock (8) projects beyond the housing and holds the pre-tensioned slider (6) in the open position, while in the clamping position of the housing the slider lock (8) is moved in relation to the open position into the inside of the housing and the slider (6) is released.

9. Housing according to claim 8, **characterised in that** the slider (6) is disposed on the outer side of the housing (1) and is guided by means of suspension tabs (7) in corresponding cutouts of the housing.

10. Housing according to claim 8 or 9, **characterised in that** the slider lock (8) is supported to allow movement in a straight-line direction on the inner side of the housing (1) and indeed to allow movement at right angles to that direction in which the slider (6) is able to be moved from the open position into the clamped position.

11. Housing according to one of claims 8 to 10, **characterised in that** the slider (6), for holding the slider in the open position, has an, especially exchangeable, latching hook (14) which rests against the housing (1) and holds the slider in an open position.

## Revendications

1. Fixation par serrage pour la fixation d'un boîtier (1) sur un rail (2), par exemple un profilé chapeau, comprenant une coulisse (6) qui peut être bloquée par serrage sur le rail (2), **caractérisée en ce que** pour raccorder en même temps le boîtier (1) à un boîtier (3) voisin déjà fixé sur le rail, la coulisse (6) peut être amenée dans la position de serrage au moyen d'un dispositif de blocage de coulisse (8), réalisé comme une autre coulisse, qui peut être actionné par le boîtier (3) voisin, et **en ce que** la coulisse (6) comporte en outre un dispositif de verrouillage de boîtier (13) pour verrouiller le boîtier (1) avec le boîtier (3) voisin lorsque la coulisse (6) est amenée dans la position de serrage.

2. Fixation par serrage selon la revendication 1, **caractérisée en ce que** le dispositif de blocage de coulisse (8) est coulissante dans une direction en ligne droite, perpendiculaire à la direction dans laquelle la coulisse (6) peut coulisser dans la position de serrage.

3. Fixation par serrage selon la revendication 1 ou 2, **caractérisée en ce que** le dispositif de blocage de coulisse (8) comporte un élément (11) pouvant être précontraint dans la direction de déplacement du dispositif de blocage de coulisse et au moyen duquel le dispositif de blocage de coulisse peut être fixé sur la face interne d'un boîtier (1).

4. Fixation par serrage selon l'une des revendications 1 à 3, **caractérisée en ce que** le dispositif de verrouillage de boîtier (13) est relié rigidement à la coulisse (6).

5. Fixation par serrage selon l'une des revendications 1 à 4, **caractérisée en ce que** la coulisse (6) est réalisée de manière plane.

6. Fixation par serrage selon l'une des revendications 1 à 5, **caractérisée en ce que** la coulisse (6) comporte au moins une patte d'accrochage (7) qui peut s'encliqueter dans un évidement (12) du dispositif de blocage de coulisse (8) pour obtenir la position de serrage de la coulisse.

7. Fixation par serrage selon l'une des revendications 1 à 6, **caractérisée en ce que** la coulisse (6) comporte un crochet d'encliquetage (14), notamment échangeable, pour maintenir la coulisse dans la position ouverte.

8. Boîtier (1) doté d'une fixation par serrage selon l'une des revendications 1 à 7, **caractérisé en ce que** la coulisse (6) est montée de manière coulissante dans une direction en ligne droite dans le boîtier, **en ce que** le dispositif de blocage de coulisse (8) est monté de manière coulissante dans une direction perpendiculaire à celle-ci dans le boîtier, **en ce que** le dispositif de verrouillage de boîtier (13) déborde partiellement à travers le boîtier, sachant que dans la position libre du boîtier, le dispositif de blocage de coulisse (8) déborde au-dessus le boîtier et maintient la coulisse (6) précontrainte en position ouverte, alors que dans la position de serrage du boîtier le dispositif de blocage de coulisse (8) se trouve déplacé vers l'intérieur du boîtier par rapport à la position ouverte et la coulisse (6) est libérée.

9. Boîtier selon la revendication 8, **caractérisé en ce que** la coulisse (6) est disposée sur la face externe du boîtier (1) et est guidée au moyen de pattes d'accrochage (7) dans des évidements correspondants du boîtier.

10. Boîtier selon la revendication 8 ou 9, **caractérisé en ce que** le dispositif de blocage de coulisse (8) est monté sur la face interne du boîtier (1) de manière à coulisser dans une direction en ligne droite, perpendiculaire à la direction dans laquelle la coulisse (6) peut coulisser de la position ouverte dans la position de serrage.

11. Boîtier selon la revendication 8 à 10, **caractérisé en ce que** la coulisse (6) comporte un crochet d'encliquetage (14), notamment échangeable, pour maintenir la coulisse dans la position ouverte, lequel crochet s'appuie contre le boîtier (1) et maintient la coulisse en position ouverte.
